# EUROPEAN PATENT APPLICATION

(11) **EP 4 788 088 A1**
(43) Date of publication of application: **05.08.2026**
(21) Application number: 25813245.5
(22) Date of filing: 12.06.2025
(51) Int. Cl.: H10D 64/27

(54) **TRENCH GATE LDMOS STRUCTURE AND FABRICATION METHOD THEREFOR**

(30) Priority: 18.12.2024 CN 202411874372
(71) Applicant: Hangzhou Fullsemi Semiconductor Co., Ltd., Hangzhou, Zhejiang 311418 (CN)
(72) Inventor: TIAN, Binwei, Hangzhou, Zhejiang 311418 (CN)
(74) Representative: Canzler & Bergmeier Patentanwälte Partnerschaft mbB
(86) International application number: PCT/CN2025/100633
(87) International publication number: WO 2026/129573

(57) **Abstract**

A trench gate LDMOS structure and method for preparing the same. By expanding the critical dimension (CD) of the gate trench from a deep trench region to a region of the first well region adjacent to deep trench region, an inverted L-shaped gate trench is formed, effectively increasing the process window for etching to form the gate trench and reducing the etching difficulty. In addition, based on the inverted L-shaped gate trench, a gate structure formed subsequently is also inverted L-shaped as a whole. Therefore, when electrically leading out the gate structure, an increased caliber of an upper portion of the gate structure effectively expands the photolithography process window for forming lead-out electrode holes on the gate structure. This not only reduces the precision requirement for lithography machines, but also lowers the requirement for overlay accuracy when forming the lead-out electrode holes on the gate structure.

## Description

### FIELD OF THE INVENTION

The present disclosure generally relates to the technical field of semiconductor devices, particularly to a trench gate LDMOS structure and method for preparing the same.

### BACKGROUND OF THE INVENTION

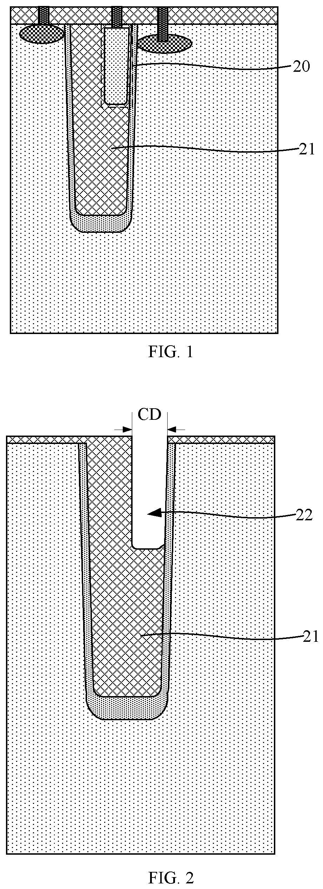

Trench LDMOS (i.e., Lateral Double-Diffused Metal-Oxide-Semiconductor) demonstrates significant advantages in the power management field, thanks to its high integration density, strong current-carrying capacity, low on-resistance, fast switching performance, high reliability, low noise, as well as miniaturization and lightweight characteristics. FIG. 1 shows a currently optimized trench LDMOS structure, whose gate is a T-shaped trench gate. Specifically, a trench gate structure 20 of the LDMOS is formed in an insulated deep trench 21. This design not only reduces energy loss and improves efficiency, but also enhances the device's durability and reliability by optimizing thermal characteristics. Despite its relatively complex manufacturing process, the high efficiency and high reliability of trench LDMOS reduce the overall system cost, improve economic efficiency, and expand the application scope. It has become a preferred semiconductor device especially in applications pursuing high efficiency and compact design, such as switching power supplies, DC/DC converters, and motor drives.

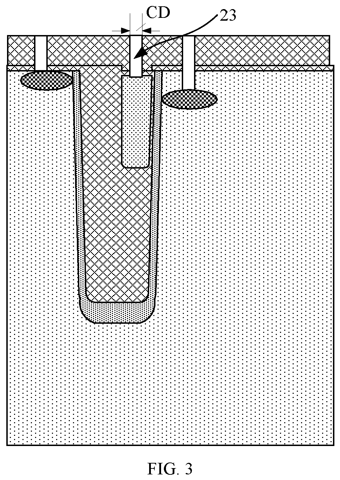

With the development of miniaturization and integration of semiconductor devices, as shown in FIG. 2, the optimized trench LDMOS structure places higher requirements on the etching process when forming the gate trench 22 with a smaller critical dimension (CD). In addition, as shown in FIG. 3, correspondingly, when electrically leading out the trench gate structure 20, lead-out electrode holes 23 with a smaller CD also impose high requirements on the photolithography process. Furthermore, due to the small CD of the trench gate structure 20, higher requirements are also put forward for the overlay accuracy during the subsequent electrical leading out of the trench gate structure. As a result, the fabrication of the entire structure relies heavily on high-precision photolithography machines, which increases manufacturing costs.

### SUMMARY OF THE INVENTION

In view of the shortcomings of the aforementioned technology, the present disclosure provides a trench gate LDMOS structure and a method for preparing the same, which are used to solve the problems in the related technology where the T-shaped trench gate LDMOS structure increases the difficulty of the etching process, has high dependence on high-precision photolithography machines, and thus raises manufacturing costs.

The method for preparing the trench gate LDMOS structure comprises:
providing a semiconductor substrate, where the semiconductor substrate comprises a first well region extending inward from a top surface of the semiconductor substrate, wherein the first well region is of a first doping type;
forming a deep trench in the first well region, wherein the deep trench extends inward from a top surface of the first well region;
performing ion implantation on side walls and a bottom wall of the deep trench to form a first-doping-type doped layer extending from the deep trench into the first well region;
disposing an insulating material, wherein at least the deep trench is completely filled by the insulating material;
etching the insulating material in a first region of the deep trench adjacent to a sidewall of the deep trench from top to bottom to a first preset depth, and etching a second region of the first well region adjacent to the first region of the deep trench from top to bottom to a second preset depth, wherein the second preset depth is smaller than the first preset depth, wherein the first region and the second region form an inverted L-shaped gate trench;
sequentially forming a gate dielectric layer and a gate conductive layer in the gate trench to form a gate structure;
forming a source doped layer and a drain doped layer in the first well region on two sides of the deep trench respectively, wherein the source doped layer and the drain doped layer are of a second doping type, wherein the source doped layer is closer to the gate structure than the drain doped layer is, wherein the first doping type is opposite to the second doping type; and
forming electrode lead-out structures to electrically lead out the gate structure, the source doped layer, and the drain doped layer respectively.

Optionally, a caliber of an upper portion of the gate trench is not less than 0.1 µm, and the second preset depth is not less than 500 Å.

Optionally, before forming the first-doping-type doped layer, the method further comprises forming a pad oxide layer over the deep trench.

Optionally, after disposing the insulating material to at least completely fill the deep trench, the method further comprises planarizing the insulating material, wherein a top surface of the planarized insulating material is higher than a top surface of the semiconductor substrate by a preset thickness, wherein the insulating material within the preset thickness serves as a hard mask layer.

Further, a method for forming the gate trench comprises:
forming a hard mask layer and a photoresist layer sequentially over the semiconductor substrate;
patterning the hard mask layer by a photolithography process using the photoresist layer to form a patterned hard mask layer, where the patterned hard mask layer exposes the insulating material in the first region of the deep trench and exposes the second region of the first well region; and
using the photoresist layer and the patterned hard mask layer as masks to etch the corresponding insulating material and the first well region, thereby forming the gate trench.

Further, a method for forming the gate structure comprises:
forming the gate dielectric layer over the gate trench by thermal oxidation;
forming the gate conductive layer over the gate dielectric layer by chemical vapor deposition, wherein the gate conductive layer at least completely fills the gate trench; and
polishing the gate conductive layer by chemical mechanical polishing, wherein, after polishing, a top surface of the gate conductive layer is lower than the top surface of the first well region.

Further, after forming the gate structure, the method for preparing the trench gate LDMOS structure further comprises: forming an insulating cladding layer over the semiconductor substrate, wherein the insulating cladding layer covers the gate structure.

Further, the method for preparing the trench gate LDMOS structure comprises: forming a second well region extending inward from the top surface of the semiconductor substrate, wherein the second well region is of a second doping type, wherein the second well region is in contact with the first well region; and after forming the insulating cladding layer, forming a shallow-trench-isolation structure in the second well region.

The present disclosure also provides a trench gate LDMOS structure, comprising:
a semiconductor substrate, where the semiconductor substrate comprises a first well region extending inward from a top surface of the semiconductor substrate, wherein the first well region is of a first doping type;
a deep trench, wherein the deep trench extends inward from a top surface of the first well region;
a first-doping-type doped layer extending from the deep trench into the first well region;
a gate structure comprising a gate dielectric layer and a gate conductive layer, wherein a first part of the gate structure is formed in a first region of the deep trench adjacent to a sidewall of the deep trench and has a first preset depth, wherein a second part of the gate structure is formed in a second region of the first well region adjacent to the first region of the deep trench, and has a second preset depth;
an insulating material, which at least completely fills the deep trench excluding the gate structure;
a source doped layer and a drain doped layer, both of which are of a second doping type, wherein the source doped layer is closer to the gate structure than the drain doped layer is, wherein the first doping type is opposite to the second doping type; and
electrode lead-out structures, which electrically lead out the gate structure, the source doped layer, and the drain doped layer.

Optionally, a caliber of an upper portion of the gate structure is not less than 0.1 µm, and the second preset depth is not less than 500 Å.

In summary, in the presently disclosed trench gate LDMOS structure and method for preparing the same, by expanding a critical dimension (CD) of a gate trench from a deep trench region to a region of a first well region adjacent to the deep trench region, an inverted L-shaped gate trench is formed, effectively increasing the process window for etching to form the gate trench and reducing the etching difficulty. In addition, based on the inverted L-shaped gate trench, a gate structure formed subsequently is also inverted L-shaped as a whole. Therefore, when electrically leading out the gate structure, an increased caliber of an upper portion of the gate structure effectively expands the photolithography process window for forming lead-out electrode holes on the gate structure. This not only reduces the precision requirement for lithography machines, but also lowers the requirement for overlay accuracy when forming the lead-out electrode holes on the gate structure.

### BRIEF DESCRIPTION OF DRAWINGS

FIG. 1 is a cross-sectional diagram of an exemplary trench LDMOS structure.
FIG. 2 is a cross-sectional diagram showing formation of a gate trench during preparation of the trench LDMOS structure in FIG. 1.
FIG. 3 is a cross-sectional diagram showing formation of lead-out electrode holes during preparation of the trench LDMOS structure in FIG. 1.
FIGs. 4 to 19 are cross-sectional diagrams showing various steps in a method for preparing a trench gate LDMOS structure according to embodiments of the present disclosure.

### Reference Numerals

- 10: Semiconductor substrate
- 100: First well region
- 101: Second well region
- 102: Deep trench
- 103: Pad oxide layer
- 104: First-doping-type doped layer
- 105: Insulating material
- 106: Hard mask layer
- 107: Photoresist layer
- 108: Patterned hard mask layer
- 11: Gate structure
- 110: Gate trench
- 111: Gate dielectric layer
- 112: Gate conductive layer
- 12: Insulating cladding layer
- 13: Shallow-trench-isolation structure
- 14: Source doped layer
- 15: Drain doped layer
- 16: Electrode lead-out structure
- 17: Dielectric layer
- 160: Lead-out electrode holes
- 20: Trench gate structure
- 21: Insulated deep trench
- 22: Gate trench
- 23: Lead-out electrode holes

### DETAILED DESCRIPTION

The embodiments of the present disclosure will be described below. Those skilled can easily understand advantages and effects of the present disclosure according to contents disclosed by the specification. The present disclosure can also be implemented or applied through other different exemplary embodiments. Various modifications or changes can also be made to all details in the specification based on different points of view and applications without departing from the spirit of the present disclosure.

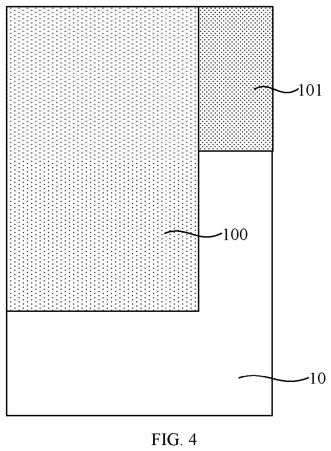

Please refer to FIGs. 4 to 19. It should be noted that the drawings provided in this disclosure only illustrate the basic concept of the present disclosure in a schematic way, so the drawings only show the components closely related to the present disclosure. The drawings are not necessarily drawn according to the number, shape, and size of the components in actual implementation; during the actual implementation, the type, quantity, and proportion of each component can be changed as needed, and the components' layout may also be more complicated.

The present disclosure provides a method for preparing a trench gate LDMOS structure, which includes steps S1 to S8.
S1: providing a semiconductor substrate, where the semiconductor substrate includes a first well region extending inward from a top surface of the semiconductor substrate, wherein the first well region is of a first doping type;
S2: forming a deep trench in the first well region, wherein the deep trench extends inward from a top surface of the first well region;
S3: performing ion implantation on side walls and a bottom wall of the deep trench to form a first-doping-type doped layer extending from the deep trench into the first well region;
S4: disposing an insulating material, wherein at least the deep trench is completely filled by the insulating material;
S5: etching the insulating material in a first region of the deep trench adjacent to a sidewall of the deep trench from top to bottom to a first preset depth, and etching a second region of the first well region adjacent to the first region of the deep trench from top to bottom to a second preset depth, wherein the second preset depth is smaller than the first preset depth, wherein the first region and the second region form an inverted L-shaped gate trench;
S6: sequentially forming a gate dielectric layer and a gate conductive layer in the gate trench to form a gate structure;
S7: forming a source doped layer and a drain doped layer in the first well region on two sides of the deep trench respectively, wherein the source doped layer and the drain doped layer are of a second doping type, wherein the source doped layer is closer to the gate structure than the drain doped layer is, wherein the first doping type is opposite to the second doping type; and
S8: forming electrode lead-out structures to electrically lead out the gate structure, the source doped layer, and the drain doped layer respectively.

In the presently disclosed trench gate LDMOS structure and method for preparing the same, by expanding a critical dimension (CD) of the gate trench from a deep trench region to a region of the first well region adjacent to the deep trench region, an inverted L-shaped gate trench is formed, effectively increasing the process window for etching to form the gate trench and reducing the etching difficulty. In addition, based on the inverted L-shaped gate trench, a gate structure formed subsequently is also inverted L-shaped as a whole. Therefore, when electrically leading out the gate structure, an increased caliber of an upper portion of the gate structure effectively expands the photolithography process window for forming lead-out electrode holes on the gate structure. This not only reduces the precision requirement for lithography machines, but also lowers the requirement for overlay accuracy when forming the lead-out electrode holes on the gate structure.

The following is a detailed description of the method for preparing the trench gate LDMOS structure with reference to the drawings.

As shown in FIG. 4, step S1 is first carried out, which includes providing a semiconductor substrate 10 including a first well region 100 extending inward from a top surface of the semiconductor substrate 10.

The semiconductor substrate 10 may a single semiconductor substrate made of silicon, germanium silicon, or silicon carbide, and it may also be a semiconductor substrate with an epitaxial layer formed thereon. The semiconductor substrate can be an intrinsic semiconductor substrate or a doped semiconductor substrate. When the semiconductor substrate 10 is a doped semiconductor substrate, its doping type is set according to the type of LDMOS to be prepared. For example, when a P-type LDMOS is to be prepared, the semiconductor substrate 10 is a P-type doped semiconductor substrate. When a N-type LDMOS is to be prepared, the semiconductor substrate 10 is an N-type doped semiconductor substrate. As an example, the semiconductor substrate 10 is a silicon substrate.

As an example, the first well region 100 can be formed through ion implantation diffusion, and the first doping type can be either P-type or N-type, which is opposite to the doping type of the semiconductor substrate 10. For instance, if the semiconductor substrate 10 is a P-type doped semiconductor substrate, then the first well region 100 is an N-type well region. When the semiconductor substrate 10 is an N-type doped semiconductor substrate, then the first well region 100 is a P-type well region.

As an example, as shown in FIG. 4, a terminal protection structure is usually formed around the periphery of the device region. Therefore, the semiconductor substrate 10 also includes a second well region 101 in contact with the first well region 100 so that the required terminal protection structure can be formed in the second well region 101. The second well region 101 can also be formed through ion implantation diffusion. The first doping type is opposite to the second doping type, that is, when the first doping type is N-type, the second doping type is p-type; when the first doping type is P-type, the second doping type is N-type.

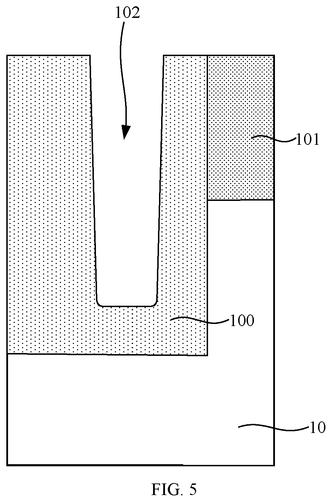

As shown in FIG. 5, step S2 includes forming a deep trench 102 within the first well region 100, wherein the deep trench 102 extends inward from a top surface of the first well region 100.

Specific parameters of the deep trench 102, such as depth and width, may be adjusted as needed.

As a specific example, a method for forming the deep trench 102 includes: first, forming a hard mask layer and a photoresist layer sequentially over the semiconductor substrate 10; then, patterning the photoresist layer by photolithography; then, patterning the hard mask layer by photolithography using the patterned photoresist layer to form a patterned hard mask layer; then, based on the patterned hard mask layer, etching the exposed semiconductor substrate 10 to obtain the deep trench 102; finally, removing the patterned hard mask layer.

As an example, to avoid local electric field concentration in subsequent LDMOS devices, corners of the deep trench 102 may be rounded.

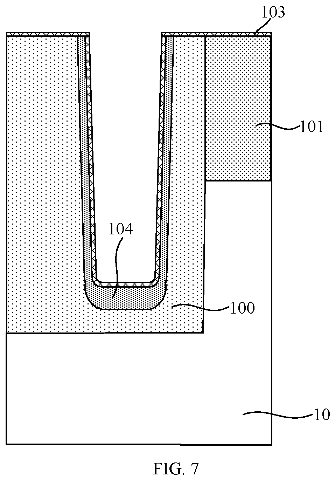

As shown in FIG. 7, step S3 includes: performing ion implantation on sidewalls and a bottom wall of the deep trench 102 to form a first-doping-type doped layer 104 surrounding the deep trench 102 and extending from the deep trench 102 into the first well region 100.

The first-doping-type doped layer 104 is subsequently used as a drift region and a channel region of the LDMOS structure.

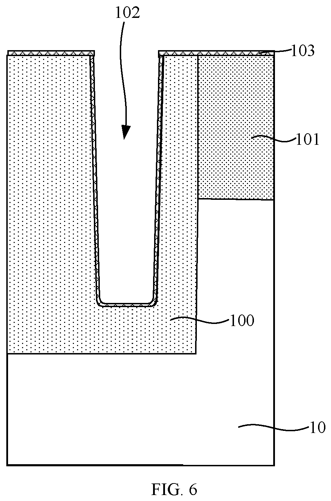

As shown in FIG. 6, as an example, a pad oxide layer 103 may be formed over the deep trench 102 before the formation of the first-doping-type doped layer 104. For example, the pad oxide layer 103 may be formed by a chemical vapor deposition (CVD) process or a thermal oxidation process. When the semiconductor substrate 10 is a silicon substrate, the pad oxide layer 103 is a silicon oxide pad oxide layer. The pad oxide layer 103 can serve as a surface barrier layer when ion implantation is performed on the first-doping-type doped layer 104, effectively mitigating the tunneling effect during ion implantation and ensuring the uniformity of ion implantation. Preferably, a thermal oxidation process is used to form the pad oxide layer 103. The pad oxide layer 103 can be used as a surface barrier layer when the first-doping-type doped layer 104 undergoes ion implantation. Also, forming the pad oxide layer 103 by the thermal oxidation process can repair surface damages caused by etching that forms the deep trench 102.

For example, when the first-doping-type doped layer 104 is of N-type, the doping ions can be N-type conductive ions such as P (phosphorus) ions and As (arsenic) ions. When the first-doping-type doped layer 104 is of P-type, the doping ions can be P-type conductive ions such as B (boron) ions and Al (aluminum) ions.

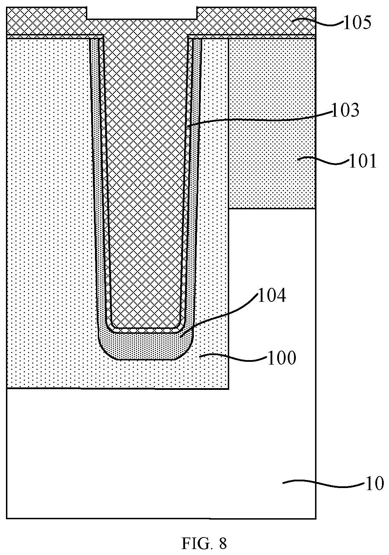

As shown in FIG. 8, step S4 includes: disposing an insulating material 105, wherein at least the deep trench 102 is completely filled by the insulating material 102.

The deep trench 102 may be filled by a CVD process or a high-aspect-ratio process (HARP), both of which have a strong filling capacity. The insulating material 105 may be any suitable insulating filling material. When the semiconductor substrate 10 is a silicon substrate, the insulating material is preferably a silicon oxide material.

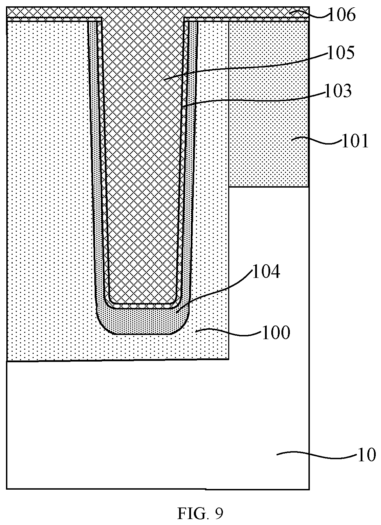

As shown in FIG. 9, as an example, after the insulating material 105 at least fills the deep trench 102, the insulating material 105 may also be planarized to facilitate subsequent processes. For example, a chemical mechanical polishing (CMP) process may be adopted for the planarization. After planarizing the insulating material 105, the top surface of the insulating material 105 may be flush with the top surface of the semiconductor substrate 10 or higher than the top surface of the semiconductor substrate 10 by a preset thickness (as shown in FIG. 9). It is preferred that after planarization, the top surface of the insulating material 105 is higher than the top surface of the semiconductor substrate 10 by the preset thickness. In this case, the insulating material within the preset thickness can be directly used as a hard mask layer for subsequent etching to form the gate trench, so as to reduce process steps and lower manufacturing costs.

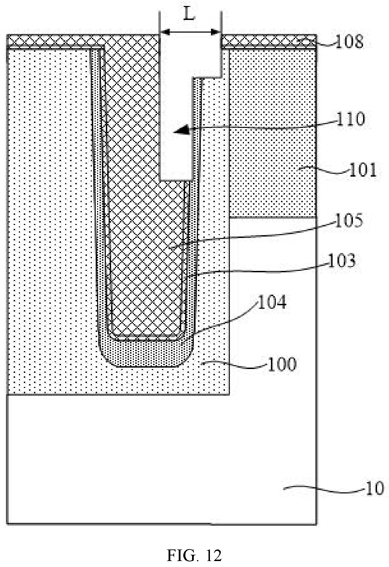

As shown in FIG. 12, step S5 includes: etching the insulating material 105 in a first region of the deep trench 102 adjacent to a sidewall of the deep trench 102 from top to bottom to a first preset depth, and etching a second region of the first well region 100 adjacent to the first region of the deep trench 102 from top to bottom to a second preset depth, wherein the second preset depth is smaller than the first preset depth, and the first region and the second region form an inverted L-shaped gate trench 110.

It should be noted that the overall shape of the gate trench 110 resembles an inverted L. When the gate trench 110 is located on different side walls of the deep trench 102 in different directions, the inverted L-shaped gate trench 110 may look differently from a certain view point. As shown in FIG. 12, when the gate trench 110 is on a right side wall of the deep trench 102, then the shape of the gate trench 110 resembles a "Γ". Similarly, when the gate trench 110 is on a left side wall of the deep trench 102, the shape of the gate trench 110 resembles a "┐".

As shown in FIG. 12, since the gate trench 110 is configured to shape like an inverted L, a caliber L of an upper portion of the gate trench 110 is significantly increased, which effectively expands the etching process window for forming the gate trench 110 through etching and reduces the etching difficulty. In addition, when forming the gate trench 110 by etching, the depth ratio between the "|" part and the "-" part of the inverted L-shaped gate trench 110 can be fine-tuned by adjusting an etching selectivity ratio between the insulating material 105 and a material of the semiconductor substrate.

As shown in FIG. 12, for example, the caliber L of the upper portion of the gate trench is not less than 0.1 µm. In addition, to ensure that, during subsequent processes of fabricating electrode lead-out structures for the gate structure, over-etching to form lead-out electrode holes does not etch through the gate structure, the second preset depth-i.e., the depth of the "-" part of the gate trench 110-is not less than 500 Å.

As a specific example, a method for forming the gate trench 110 includes steps S51-S53.

S51, as shown in FIG. 9, includes: forming a hard mask layer 106 over the semiconductor substrate 10. It should be noted here that after planarizing the insulating material 105 in step S4, if the top surface of the insulating material 105 is flush with the top surface of the semiconductor substrate 10, a hard mask layer 106 needs to be formed over the semiconductor substrate 10 in this step. If the top surface of the insulating material 105 after planarizing is higher than the semiconductor substrate 10 by the preset thickness, then the insulating material 105 within this preset thickness is directly used as the hard mask layer 106 in this step.

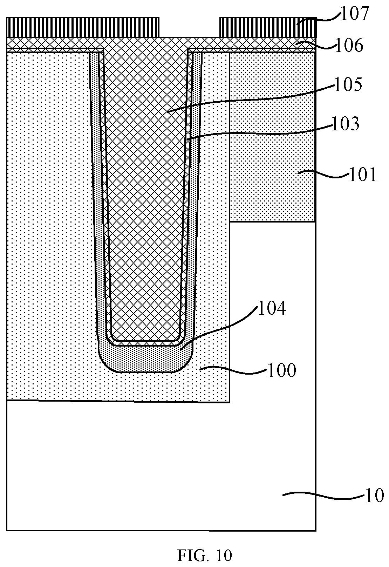

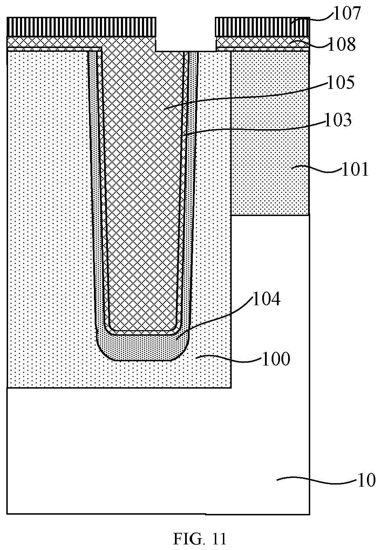

S52, as shown in FIGs. 10 and 11, includes: forming a patterned photoresist layer 107 (as shown in FIG. 10) on the hard mask layer 106, and etching the hard mask layer 106 using the patterned photoresist layer 107 as a mask to form a patterned hard mask layer 108 (as shown in FIG. 11). The patterned hard mask layer 108 exposes the insulating material 105 in the first region of the deep trench 102 and exposes the second region of the first well region 100. This step can also effectively reduce the precision requirement for lithography machines.

S53, as shown in FIG. 12, includes: using the patterned photoresist layer 107 and the patterned hard mask layer 108 as masks to etch the corresponding insulating material 105 and the first well region 100, thereby forming the gate trench 110. Finally, the patterned photoresist layer 107 is removed.

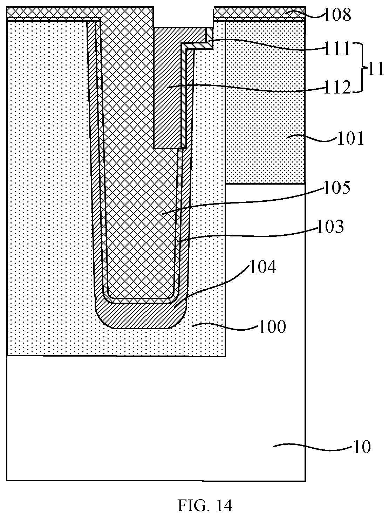

As shown in FIG. 14, step S6 includes: sequentially forming a gate dielectric layer 111 and a gate conductive layer 112 in the gate trench 110, thereby forming a gate structure 11.

When the semiconductor substrate 10 is a silicon substrate, the gate dielectric layer 111 is a silicon oxide gate dielectric layer, preferably formed by a thermal oxidation process, and the gate conductive layer 112 is a polysilicon gate conductive layer.

As a specific example, a method for forming the gate structure 11 includes steps S61-S63.

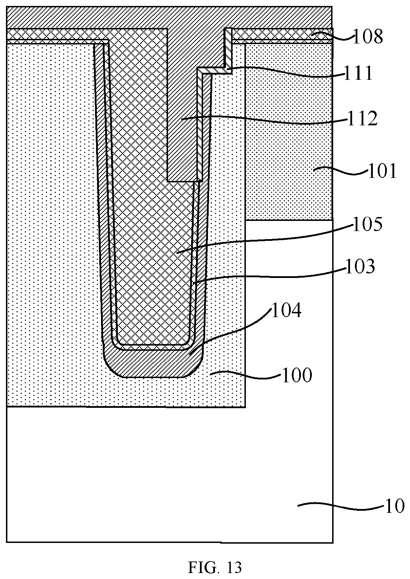

S61, as shown in FIG. 13, includes: forms the gate dielectric layer 111 over the gate trench 110 by a thermal oxidation process.

S62, as shown in FIG. 13, includes: forming the gate conductive layer 112 over the gate dielectric layer 111 by CVD, wherein the gate conductive layer 112 at least completely fills the gate trench 110.

S63, as shown in FIG. 14, includes: polishing the gate conductive layer 112 by CMP, wherein, after polishing, a top surface of the gate conductive layer 112 is lower than the top surface of the first well region 100.

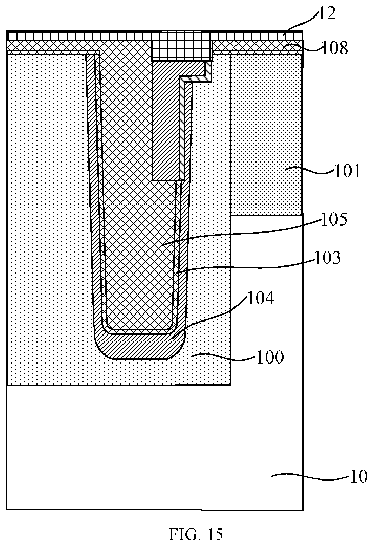

As shown in FIG. 15, the method further includes, after forming the gate structure 11, forming an insulating cladding layer 12 over the semiconductor substrate, wherein the insulating cladding layer 12 covers the gate structure 11. Preferably, a material of the insulating cladding layer 12 is the same as that of the insulating material 105; for example, both are silicon oxide.

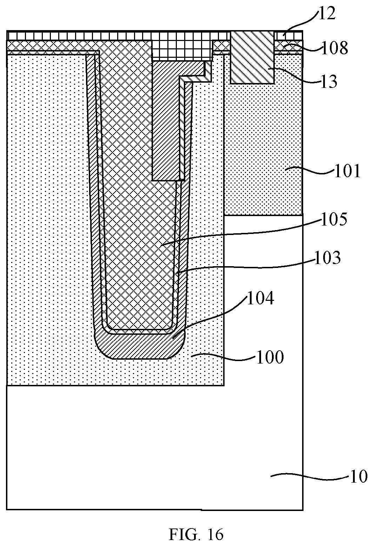

As shown in FIG. 16, the method further includes, after forming the insulating cladding layer 12, forming a shallow-trench-isolation structure 13 in the second well region 101. As mentioned above, since the top surface of the gate conductive layer 112 is lower than that of the first well region 100 after step S63, the top surface of the gate structure 11 is less likely to be damaged during planarizing of isolation materials filled in the shallow-trench-isolation structure 13.

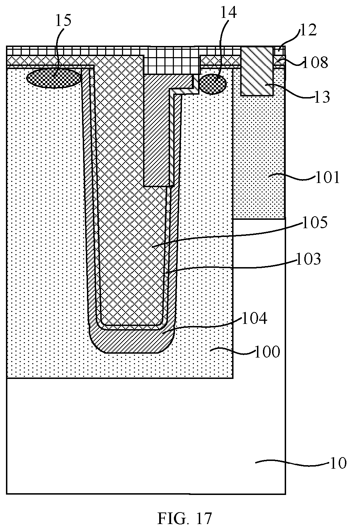

As shown in FIG. 17, step S7 includes: forming a source doped layer 14 and a drain doped layer 15 in the first well region 100 on two sides of the deep trench respectively, wherein the source doped layer 14 and the drain doped layer 15 are of a second doping type, the source doped layer 14 is closer to the gate structure 11 than the drain doped layer 15 is, and the first doping type is opposite to the second doping type.

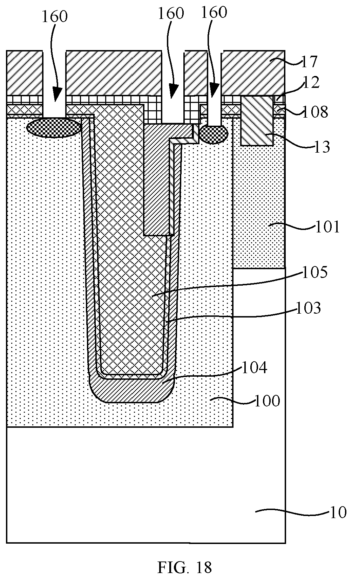

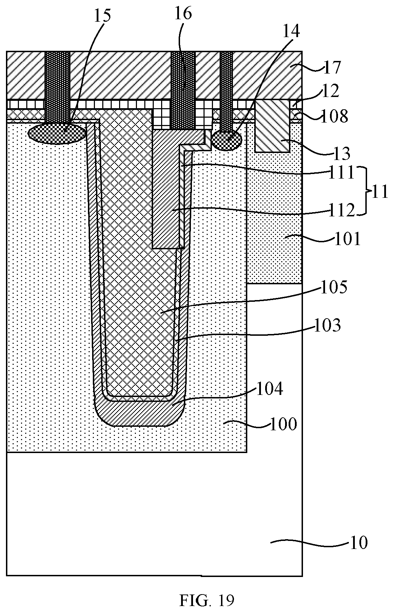

As shown in FIG. 18 and FIG. 19, step S8 includes: forming electrode lead-out structures 16 to electrically lead out the gate structure 11, the source doped layer 14, and the drain doped layer 15 respectively.

As a specific example, a method for forming the electrode lead-out structures 16 includes S81-S83.

S81, as shown in FIG. 18, includes: forming a dielectric layer 17 over the insulating cladding layer 12, and planarizing the dielectric layer 17.

S82, as shown in FIG. 18, includes: performing photolithography and etching on the dielectric layer 17 to form lead-out electrode holes 160 in the regions corresponding to the gate structure 11, the source doped layer 14, and the drain doped layer 15. As mentioned above, based on the inverted L-shaped gate trench 110, the overall gate structure 11 is also inverted L-shaped. Therefore, during the photolithography process in this step, due to the increase in the caliber of the upper portion of the gate structure 11, the photolithography process window for forming the electrode holes 160 can be effectively enlarged, thereby reducing the precision requirement for photolithography machines. At the same time, this can also reduce the overlay precision requirement for forming the lead-out electrode holes 160 on the gate structure 11.

S83, as shown in FIG. 19, includes: filling the lead-out electrode holes 160 with a conductive metal material, and planarizing the conductive metal material to remove the conductive metal material outside the lead-out electrode holes 160, thereby obtaining the electrode lead-out structures 16.

The present disclosure also provides a trench gate LDMOS structure, which can be prepared by the method described above, but is not limited thereto; any other suitable method may also be used, as long as the trench gate LDMOS structure can be obtained. When a trench gate LDMOS structure is fabricated via the method described, its associated benefits are detailed in the preceding discussion of the method.

As shown in FIG. 19, the trench gate LDMOS structure includes:
a semiconductor substrate 10, where the semiconductor substrate 10 includes a first well region 100 extending inward from a top surface of the semiconductor substrate 10, wherein the first well region 100 is of a first doping type;
a deep trench 102 (as shown in FIG. 5), wherein the deep trench 102 extends inward from a top surface of the first well region 100;
a first-doping-type doped layer 104 extending from the deep trench 102 into the first well region 100;
a gate structure 11 comprising a gate dielectric layer 111 and a gate conductive layer 112, wherein a first part of the gate structure 11 is formed in a first region of the deep trench 102 adjacent to a sidewall of the deep trench 102 and has a first preset depth, wherein a second part of the gate structure 11 is formed in a second region of the first well region 100 adjacent to the first region of the deep trench 102 and has a second preset depth;
an insulating material 105, wherein at least the deep trench 102 excluding the gate structure 11 is completely filled by the insulating material 105;
a source doped layer 14 and a drain doped layer 15, wherein the source doped layer 14 and the drain doped layer 15 are of a second doping type, wherein the source doped layer 14 is closer to the gate structure 11 than the drain doped layer 15 is, wherein the first doping type is opposite to the second doping type; and
electrode lead-out structures 16, wherein the electrode lead-out structures 16 electrically lead out the gate structure 11, the source doped layer 14, and the drain doped layer 15 respectively.

For example, a caliber of an upper portion of the gate structure 11 is not less than 0.1µm, and the second preset depth is not less than 500 Å.

In summary, in the presently disclosed trench gate LDMOS structure and method for preparing the same, by expanding a critical dimension (CD) of a gate trench from a deep trench region to a region of a first well region adjacent to the deep trench region, an inverted L-shaped gate trench is formed, effectively increasing the process window for etching to form the gate trench and reducing the etching difficulty. In addition, based on the inverted L-shaped gate trench, a gate structure formed subsequently is also inverted L-shaped as a whole. Therefore, when electrically leading out the gate structure, an increased caliber of an upper portion of the gate structure effectively expands the photolithography process window for forming lead-out electrode holes on the gate structure. This not only reduces the precision requirement for lithography machines, but also lowers the requirement for overlay accuracy when forming the lead-out electrode holes on the gate structure. Therefore, the present disclosure effectively overcomes various shortcomings in the existing technology and has high industrial utilization value.

The above-mentioned embodiments are merely illustrative of the principle and effects of the present disclosure instead of restricting the scope of the present disclosure. Any person skilled in the art may modify or change the above embodiments without violating the principle of the present disclosure. Therefore, all equivalent modifications or changes made by those who have common knowledge in the art without departing from the spirit and technical concept disclosed by the present disclosure shall be still covered by the claims of the present disclosure.

## Claims

1. A method for preparing a trench gate LDMOS structure, comprising:
providing a semiconductor substrate, where the semiconductor substrate comprises a first well region extending inward from a top surface of the semiconductor substrate, wherein the first well region is of a first doping type;
forming a deep trench in the first well region, wherein the deep trench extends inward from a top surface of the first well region;
performing ion implantation on side walls and a bottom wall of the deep trench to form a first-doping-type doped layer extending from the deep trench into the first well region;
disposing an insulating material, wherein at least the deep trench is completely filled by the insulating material;
etching the insulating material in a first region of the deep trench adjacent to a sidewall of the deep trench from top to bottom to a first preset depth, and etching a second region of the first well region adjacent to the first region of the deep trench from top to bottom to a second preset depth, wherein the second preset depth is smaller than the first preset depth, wherein the first region and the second region form an inverted L-shaped gate trench;
sequentially forming a gate dielectric layer and a gate conductive layer in the gate trench to form a gate structure;
forming a source doped layer and a drain doped layer in the first well region on two sides of the deep trench respectively, wherein the source doped layer and the drain doped layer are of a second doping type, wherein the source doped layer is closer to the gate structure than the drain doped layer is, wherein the first doping type is opposite to the second doping type; and
forming electrode lead-out structures to electrically lead out the gate structure, the source doped layer, and the drain doped layer respectively.

2. The method according to claim 1, wherein a caliber of an upper portion of the gate trench is not less than 0.1 µm, and the second preset depth is not less than 500 Å.

3. The method according to claim 1, wherein before forming the first-doping-type doped layer, the method further comprises forming a pad oxide layer over the deep trench.

4. The method according to claim 1, wherein after disposing the insulating material to at least completely fill the deep trench, the method further comprises planarizing the insulating material, wherein a top surface of the planarized insulating material is higher than a top surface of the semiconductor substrate by a preset thickness, wherein the insulating material within the preset thickness serves as a hard mask layer.

5. The method according to any of claims 1-4, wherein the gate trench is formed by:
forming a hard mask layer and a photoresist layer sequentially over the semiconductor substrate;
patterning the hard mask layer by a photolithography process using the photoresist layer to form a patterned hard mask layer, where the patterned hard mask layer exposes the insulating material in the first region of the deep trench and exposes the second region of the first well region; and
using the photoresist layer and the patterned hard mask layer as masks to etch the corresponding insulating material and the first well region, thereby forming the gate trench.

6. The method according to claim 5, wherein the gate structure is formed by:
forming the gate dielectric layer over the gate trench by thermal oxidation;
forming the gate conductive layer over the gate dielectric layer by chemical vapor deposition, wherein the gate conductive layer at least completely fills the gate trench; and
polishing the gate conductive layer by chemical mechanical polishing, wherein, after polishing, a top surface of the gate conductive layer is lower than the top surface of the first well region.

7. The method according to claim 6, wherein after forming the gate structure, the method further comprises: forming an insulating cladding layer over the semiconductor substrate, wherein the insulating cladding layer covers the gate structure.

8. The method according to claim 7, further comprising: forming a second well region extending inward from the top surface of the semiconductor substrate, wherein the second well region is of a second doping type, wherein the second well region is in contact with the first well region; and after forming the insulating cladding layer, forming a shallow-trench-isolation structure in the second well region.

9. A trench gate LDMOS structure, comprising:
a semiconductor substrate, where the semiconductor substrate comprises a first well region extending inward from a top surface of the semiconductor substrate, wherein the first well region is of a first doping type;
a deep trench, wherein the deep trench extends inward from a top surface of the first well region;
a first-doping-type doped layer extending from the deep trench into the first well region;
a gate structure comprising a gate dielectric layer and a gate conductive layer, wherein a first part of the gate structure is formed in a first region of the deep trench adjacent to a sidewall of the deep trench and has a first preset depth, wherein a second part of the gate structure is formed in a second region of the first well region adjacent to the first region of the deep trench, and has a second preset depth;
an insulating material, which at least completely fills the deep trench excluding the gate structure;
a source doped layer and a drain doped layer, both of which are of a second doping type, wherein the source doped layer is closer to the gate structure than the drain doped layer is, wherein the first doping type is opposite to the second doping type;
electrode lead-out structures, which electrically lead out the gate structure, the source doped layer, and the drain doped layer.

10. The trench gate LDMOS structure according to claim 9, wherein a caliber of an upper portion of the gate structure is not less than 0.1 µm, and the second preset depth is not less than 500 Å.
